# EUROPÄISCHE PATENTSCHRIFT

(11) **EP 2 108 190 B1**
(45) Veröffentlichungstag und Bekanntmachung des Hinweises auf die Patenterteilung: **06.12.2017**
(21) Anmeldenummer: 07703755.4
(22) Anmeldetag: 10.01.2007
(51) Int. Cl.: H01L 23/373

(54) **ELEKTRONISCHES BAUELEMENTMODUL UND VERFAHREN ZU DESSEN HERSTELLUNG**
ELECTRONIC COMPONENT MODULE AND METHOD FOR PRODUCTION THEREOF
MODULE ÉLECTRONIQUE ET PROCÉDÉ DE FABRICATION DE CELUI-CI

(43) Veröffentlichungstag der Anmeldung: 14.10.2009
(73) Patentinhaber: OSRAM GmbH, 80807 München (DE)
(72) Erfinder: MATZ, Richard, 83052 Bruckmühl (DE); MAENNER, Ruth, 85667 Oberpframmern (DE); WALTER, Steffen, 85667 Operpframmern (DE)
(86) Internationale Anmeldenummer: PCT/EP2007/050208
(87) Internationale Veröffentlichungsnummer: WO 2008/083853

(56) Entgegenhaltungen:
- EP-A- 1 202 345
- EP-A- 1 737 034
- DE-A1- 19 846 638
- JP-A- H0 585 869
- US-A- 5 354 415
- US-A- 5 650 662

## Beschreibung

### Technisches Gebiet

Die Erfindung betrifft ein elektronisches Bauelementmodul mit zumindest einem mehrlagigen keramischen Schaltungsträger, und einer Kühlungsvorrichtung mit zumindest einem Kühlkörper. Des Weiteren betrifft die Erfindung auch ein Verfahren zum Herstellen eines derartigen elektronischen Bauelementmoduls.

### Stand der Technik

Elektronische Bauelementmodule mit mehreren mehrlagigen Schaltungsträgern sind bekannt. Diese werden beispielsweise durch die LTCC (Low Temperature Cofired Ceramics) gefertigt, welche eine leistungsfähige Technologie zur Herstellung keramischer Schaltungsträger aus mehreren Einzellagen darstellt. Dafür werden keramische ungesinterte Grünfolien für die elektrischen Durchkontaktierungen durch Ausstanzen mit Öffnungen versehen, die Öffnungen werden mit elektrisch leitfähiger Paste gefüllt und die Folien werden auf ihrer Oberfläche im Siebdruckverfahren mit ebenen Leitungsstrukturen versehen. Zahlreiche dieser einzelnen Lagen können abschließend aufeinander laminiert und bei relativ niedriger Temperatur gesintert werden. Der Prozess liefert mehrlagige, vergrabene Layout-Strukturen, die sich für die Integration passiver Schaltungselemente nutzen lassen. Darüber hinaus können dadurch Layout-Strukturen geschaffen werden, welche sehr gute Hochfrequenzeigenschaften besitzen, hermetisch versiegelt sind und gute thermische Beständigkeit besitzen. Mit diesen Eigenschaften ist die LTCC-Technologie für Anwendungen in widriger Umgebung, beispielsweise für Sensoren, in der Hochfrequenztechnik, beispielsweise im Mobilfunk und Radarbereich, und in der Leistungselektronik, beispielsweise in der Fahrzeugelektronik, der Getriebe- und Motorsteuerung, geeignet. Thermisch anspruchsvolle Anwendungen sind jedoch häufig eingeschränkt durch relativ schlechte Wärmeleitfähigkeit des Materials, welches typischerweise eine Wärmeleitfähigkeit von 2 W/m K aufweist. Für die Kühlung aktiver Halbleiterbauelemente, die im Allgemeinen als oberflächenmontierte Bauteile Teil von derartigen LTCC-Modulen sind, reicht die bloße Montage des LTCC-Substrates auf einem Kühlkörper nicht aus. Insbesondere ein Auflöten oder Aufkleben eines LTCC-Substrates auf einen Kühlkörper, wie dies in J. Schulz-Harder et al.: "Micro channel water cooled power modules", Seiten 1 bis 6, PCIM 2000 Nürnberg, beschrieben ist, reicht nicht aus.

Eine LTCC-Keramik ist im Standardprozess mit Silber-Metallisierung kompatibel. Eine übliche Lösung für LTCC-Substrate ist deshalb die Integration thermischer Vias. Dies sind vertikale Durchkontaktierungen, die mit silbergefüllter, leitfähiger Paste gefüllt sind und primär der Entwärmung dienen. Auf diese Weise ist eine mittlere Wärmeleitfähigkeit von 20 W/m K erreichbar. In Kombination mit silbergefüllten Folien wurden Werte von 90 W/m K und 150 W/m K in vertikaler beziehungsweise horizontaler Richtung ermöglicht. Dies ist aus M. A. Zampino et al.: "LTCC substrates with internal cooling channel and heat exchanger", Proc. Internat. Symp. on Microelectronics 2003, Internat. Microelectronics and Packaging Society (IMAPS), 18. - 20.11.2003, Boston, USA offenbart.

Eine weitere Lösung ist die Montage von Halbleiter-ICs (integrated circuits) mit hoher Verlustwärme, beispielsweise Leistungsverstärker, in Aussparungen der LTCC-Platine direkt auf der Wärmesenke.

Weiterhin sind Lösungen bekannt, welche auf der Integration von flüssigkeitsgefüllten Kanälen basieren. Dabei erfolgt die Kühlung durch Konvektion einer Flüssigkeit mit hoher Wärmekapazität, beispielsweise Wasser, wie dies in dem oben genannten Stand der Technik gemäß J. Schulz-Harder et al.: "Micro channel water cooled power modules", und des Weiteren in M. A. Zampino et al.: "Embedded heat pipes with MCM-C Technology", Proc. NEPCON West 1998 Conference Vol. 2, Reed Exhibition: Norwalk, CT USA 1998, Seiten 777 - 785, Vol. 2, (Conf. Anaheim, USA, 1. - 5.03.1998) beschrieben ist.

Eine darauf aufbauende Lösung nützt für den Wärmetransport nicht die Wärmekapazität der Kühlflüssigkeit, sondern die latente Wärme eines Phasenübergangs. Dies ist im oben genannten Stand der Technik gemäß M. A. Zampino et al.: "LTCC substrates with internal cooling channel and heat exchanger" und in W. K. Jones et al.: "Thermal management in low temperature cofire ceramic (LTCC) using high density thermal vias and micro heat pipes/spreaders", Proc. Internat. Symp. on Microelectronics 2002, Internat. Microelectronics and Packaging Society (IMAPS), 10. - 13.03.2002, Reno, USA beschrieben ist. Die dort erläuterten "heat pipes" werden nach dem Stand der Technik beispielsweise für die Kühlung von Prozessoren in kompakten Rechnern, wie beispielsweise Laptops, verwendet.

Neben diesen für LTCC geeigneten Verfahren ist für hochsinternde Aluminiumoxid-Keramik der so genannte Direct Copper Bond-Prozess geeignet und weit verbreitet, um Schaltungsträger aus gesintertem Aluminiumoxid bei etwa 1100°C direkt mit Kühlfolien aus Kupfer zu verbinden. Dies ist in J. Schulz-Harder et al.: "Micro channel water cooled power modules" und J. Schulz-Harder et al.: "DBC substrate with integrated flat heat pipe", EMPC 2005, The 15th European Microelectronics and Packaging Conference & Exhibition, 12. - 15.06.2005, Brügge, Belgien, beschrieben.

Aus der EP 1202345 A2 ist ein Halbleiter Leistungsbauelement bekannt, welches zwischen einem keramischen Schaltungsträger und einem Kühlkörper ein eutektisches Lot aufweist, welches diese beiden Bauteile miteinander verbindet.

Aus der DE 19846638 A1 ist ein Mehrlagen-Kompositboard bekannt, welches aus einer Keramischen Platine und einem metallischen Blech besteht, wobei die keramische Platine und das metallische Blech mittels einer eutektischen Metallschmelze verbunden sind.

Aus der JP05-85869 A ist eine AlN-Keramik bekannt, bei welcher zur verbesserung der Metallisierung ein Aluminiumoxidfilm in einem besonderen Verfahren aufgebracht wird.

Aus der US 5650662 A ist ein Kühlkörper bekannt, der mittels einem directbond Verfahren ohne Verwendung eines Lotes oder zusätzlichen verbindungsmaterials mit einer metallisierten Keramischen Platine verbunden wird. Aus der US 5354415 A ist eine Methode zur Herstellung einer keramischen Platine bekannt,

### Darstellung der Erfindung

Der Erfindung liegt die Aufgabe zugrunde, ein elektronisches Bauelementmodul und ein Verfahren zum Herstellen eines derartigen elektronischen Bauelementmoduls zu schaffen, bei dem hochwärmeleitfähige Substrate einfach und aufwandsarm mit einem mehrlagigen keramischen Schaltungsträger stabil verbunden werden können und die Wärmeabfuhr verbessert werden kann.

Diese Aufgabe wird durch ein elektronisches Bauelementmodul, welches die Merkmale nach Patentanspruch 1 aufweist, und ein Verfahren, welches die Merkmale nach Patentanspruch 8 aufweist, gelöst.

Ein erfindungsgemäßes elektronisches Bauelementmodul umfasst zumindest einen keramischen mehrlagigen Schaltungsträger und eine Kühlungsvorrichtung mit zumindest einem Kühlkörper. Zwischen dem keramischen Schaltungsträger und der Kühlungsvorrichtung ist ein Verbundbereich zum Verbinden des Schaltungsträgers mit der Kühlungsvorrichtung ausgebildet, welcher Verbundbereich eine zumindest anteilig aus Metall ausgebildete Verbundschicht und einen eutektischen Bereich umfasst. Insbesondere ist der Verbundbereich so ausgebildet, dass die zumindest anteilig aus Metall ausgebildete Verbundschicht zur Verbindung mit einem keramischen Material, insbesondere des keramischen mehrlagigen Schaltungsträgers, ausgebildet ist. Durch eine derartige Ausgestaltung kann ein mechanisch stabiler mehrschichtiger Verbundbereich zwischen dem Schaltungsträger und der Kühlungsvorrichtung erreicht werden, welcher darüber hinaus aufwandsarm hergestellt werden kann.

Der eutektische Bereich ist in bevorzugter Weise zwischen der Verbundschicht und der metallischen Kühlungsvorrichtung angeordnet. Insbesondere bei einer metallischen Kühlungsvorrichtung kann der eutektische Bereich einen besonderen Verbund ausbilden.

Bevorzugterweise ist der Verbundbereich vollflächig zwischen dem Schaltungsträger und der Kühlungsvorrichtung ausgebildet. Dies ermöglicht eine einfache und aufwandsarme Aufbringung des Verbundbereichs. Es kann jedoch auch vorgesehen sein, dass der Verbundbereich lediglich bereichsweise zwischen dem Schaltungsträger und der Kühlungsvorrichtung ausgebildet ist. Insbesondere kann dabei vorgesehen sein, dass spezifische lokale Bereiche vorgesehen sind, an denen der Verbundbereich ausgebildet ist. Diese können bevorzugt dadurch gegeben sein, dass besonders wärmebelastete elektronische Bauteile benachbart zu diesem Verbundbereich im Schaltungsträger angeordnet sind und dadurch ein verbesserter Wärmeabtransport über den Verbundbereich und die Kühlungsvorrichtung ermöglicht werden kann, da dieser relativ nahe zu diesen Bauteilen angeordnet ist.

Bevorzugt ist die metallische Verbundschicht als Metallpaste zumindest bereichsweise auf dem Schaltungsträger aufgebracht. Besonders bevorzugt ist es, wenn diese metallische Verbundschicht als Metallpaste vor dem Zusammenfügen der Einzellagen des Schaltungsträgers mit der Kühlvorrichtung auf diesem Schaltungsträger aufgebracht ist. Besonders bevorzugt erweist es sich, wenn diese Metallpaste zur reaktiven Verbindung mit dem keramischen Schaltungsträger während des Prozesses zur Zusammenfügung der Einzellagen des Schaltungsträgers ausgebildet ist. Durch diese Ausführung kann die Ausbildung der metallischen Verbundschicht und somit der stabile Verbund zwischen dieser Metallpaste und dem keramischen Schaltungsträger während dem Prozess zum Zusammenfügen der Einzellagen des Schaltungsträgers ermöglicht werden. Die Verbundausbildung muss somit nicht mehr nachträglich zum Prozess des endgültigen Zusammenfügens des mehrlagigen Schaltungsträgers durchgeführt werden, sondern kann zumindest zeitweise überlappend mit diesem Prozess und somit auch unter diesen Prozessbedingungen ermöglicht werden. Eine wesentlich kürzere Fertigung bei gleichzeitiger Erhöhung der Stabilität und darüber hinaus verbesserter Wärmeleitfähigkeit kann dadurch erreicht werden.

Bevorzugt ist der Schaltungsträger als keramischer LTCC-Schaltungsträger ausgebildet und die Verbundschicht zur reaktiven Verbunderzeugung mit dem LTCC-Schaltungsträger während dem LTCC-Prozess zur Verbindung der Einzellagen und des keramischen Schaltungsträgers ausgebildet.

In besonders bevorzugter Weise ist der eutektische Bereich zur reaktiven Verbunderzeugung mit der Kühlungsvorrichtung während dem Prozess zur Verbindung der Einzellagen des keramischen mehrlagigen Schaltungsträgers erzeugbar. Insbesondere ist dies dann vorteilhaft, wenn der Schaltungsträger als keramischer LTCC-Schaltungsträger ausgebildet ist und der eutektische Bereich während dem LTCC-Prozess zur Verbindung der Einzellagen des keramischen Schaltungsträgers erzeugbar ist. Die durch den Binderausbrand hervorgerufene Schrumpfung des keramischen Materials wird dabei durch den Verbund mit den metallischen Zwischenlagen auf die vertikale Dimension begrenzt. Dadurch wird im Vergleich zu den aus dem Stand der Technik bekannten Verfahren zur Begrenzung der lateralen Schrumpfung eine bessere Maßhaltigkeit des Schaltungsträgers erreicht. Den unterschiedlichen thermischen Ausdehnungskoeffizienten von Metall und Keramik wird durch Begrenzung der lateralen Ausdehnung und/oder durch geeignete vertikale Lagenabfolge Rechnung getragen.

Bevorzugt wird der Verbund zwischen dem Schaltungsträger, dem Verbundbereich und der Kühlungsvorrichtung durch einen Sinterprozess bei einer Temperatur zwischen 840°C und 930°C, insbesondere bei etwa 900°C, ausgebildet. Der Verbund wird somit bevorzugt bei einer relativ niedrigen Sintertemperatur von etwa 900°C dadurch erzielt, dass der mehrlagige LTCC-Schaltungsträger auf der Kontaktfläche zum Kühlkörper der Kühlungsvorrichtung mit einer LTCCkompatiblen und somit im Prozess reaktiven Metallpaste entweder ganzflächig oder in einem speziell gewählten Muster bedruckt wird. Derartige Metallpasten können beispielsweise aus Metallpartikeln wie Silber, Gold, Platin oder Palladium sowie Glaspartikel und organischen Bindern zusammengesetzt sein. Der Glasanteil stellt dabei eine gute Haftfähigkeit auf den funktionellen LTCC-Lagen des Schaltungsträgers sicher. Darüber hinaus wird der Verbundbereich weiterhin durch einen eutektischen Bereich ausgebildet. Dieser wird insbesondere zwischen dem Kühlkörpermetall, welches bevorzugt Kupfer ist, und mit dem Metall der metallischen Verbundschicht hergestellt. Besonders bevorzugt kann vorgesehen sein, dass diese metallische Verbundschicht eine zumindest silberaufweisende LTCC-Siebdruckpaste ist.

Der Kühlkörper erstreckt sich zumindest an einer Seite lateral über die Ausmaße des Schaltungsträgers hinaus. Neben einer lateralen Kühlmöglichkeit kann dadurch auch eine einfache Montage an dieser überstehenden Seite des Kühlkörpers mit weiteren Bauelementmodulen und/oder einem Gehäuse ermöglicht werden.

Durch das erfindungsgemäße elektronische Bauelementmodul kann eine ganzflächige Materialverbindung ohne Zusatzstoffe, welche im Nachgang zur eigentlichen Fertigung im Stand der Technik aufgebracht werden muss, beispielsweise durch ein Hartlot oder durch einen Klebevorgang, allein durch metallische Reaktion zwischen Metallschichten und den Komponenten des Bauelementmoduls erreicht werden. Dadurch kann ein geringst möglicher Wärmewiderstand ermöglicht werden. Eine rein passive Entwärmung des elektronischen Bauelementmoduls ohne bewegliche Stoffe, Phasengrenzen oder Phasenübergänge kann dadurch erzielt werden.

Besonders vorteilhaft erweist sich diese Ausgestaltung des Verbundbereiches dann, wenn das elektronische Bauelementmodul eine Mehrzahl an keramischen Schaltungsträgern aufweist, zwischen denen eine Mehrzahl an Kühlungsvorrichtungen, insbesondere Kühlkörper als Zwischenlagen ausgebildet sind. Bei einer derartigen integralen Ausbildung werden somit Stapel von keramischen Schaltungsträgern mit dazwischen integrierten Kühlkörpern ausgebildet. Insbesondere bei solchen komplexen Systemen kann durch das vorgeschlagene elektronische Bauelementmodul mit derartigen Verbundbereichen eine wesentliche Verbesserung im Hinblick auf Stabilität und Funktionalität gewährleistet werden. Nicht zuletzt kann auch die Herstellung derart komplexer Systeme wesentlich schneller und kostengünstiger ermöglicht werden. Insbesondere kann dies deshalb erreicht werden, da die Ausbildung des gesamten endgültigen Verbundbereichs im Wesentlichen zeitgleich mit der eigentlichen Verbundherstellung des oder der mehrlagigen Schaltungsträger erfolgt.

Darüber hinaus ist auch eine effiziente Entwärmung von vergrabenen Bauteilen in dem keramischen Schaltungsträger, insbesondere einem LTCC-Schaltungsträger, möglich. Als Bauteile seien hier beispielsweise Ferrite und Widerstände genannt. Nicht zuletzt ist ein weiterer Vorteil darin begründet, dass die Kühlkörper auch als integrierte Folien, insbesondere Kupferfolien, ausgebildet werden können und somit auch als hochstromfähige Leiter verwendet werden können.

Die Kompaktheit und Minimierung in den Ausmaßen kann dadurch ebenfalls erreicht werden.

Bei einem erfindungsgemäßen Verfahren zum Herstellen eines elektronischen Bauelementmoduls wird zumindest ein mehrlagiger keramischer Schaltungsträger ausgebildet und mit einer Kühlungsvorrichtung mit zumindest einem Kühlkörper verbunden. Der Schaltungsträger und die Kühlungsvorrichtung werden durch einen Verbundbereich verbunden, welcher Verbundbereich durch eine zumindest anteilig aus Metall ausgebildete Verbundschicht und einem eutektischen Bereich ausgebildet wird. Dieses zumindest zweischichtige System des Verbundbereichs ermöglicht eine optimale Anbindung an den Schaltungsträger einerseits, welcher aus einem ersten Material ausgebildet ist, und der Kühlungsvorrichtung andererseits, welche aus einem zweiten Material ausgebildet ist. Neben der stabilen Verbindung kann diese auch aufwandsarm erzeugt werden.

Bevorzugt wird die metallische Verbundschicht vor dem Aufbringen des Schaltungsträgers an der Kühlungsvorrichtung an diesem Schaltungsträger als zumindest bereichsweise aufgetragene Metallpaste ausgebildet. Der eutektische Bereich wird bevorzugterweise zwischen der metallischen Verbundschicht und der Kühlungsvorrichtung ausgebildet. Besonders bevorzugt erweist es sich, wenn der eutektische Bereich während dem Verbinden zwischen dem Schaltungsträger, der Verbundschicht und der Kühlungsvorrichtung ausgebildet wird. Der eutektische Bereich wird bevorzugt durch eine Materialverbindung mit einer Schmelztemperatur kleiner der Prozesstemperatur, bei der der Schaltungsträger, die Verbundschicht und die Kühlungsvorrichtung miteinander verbunden werden, ausgebildet. Der Schaltungsträger, die Verbundschicht und die Kühlungsvorrichtung werden bevorzugt durch Sintern bei einer Temperatur zwischen 840°C und 930°C, insbesondere bei etwa 900°C, verbunden.

Besonders bevorzugt erweist es sich, wenn der Schaltungsträger als keramischer LTCC-Schaltungsträger ausgebildet wird und der eutektische Bereich zur reaktiven Verbunderzeugung mit der Kühlungsvorrichtung während dem LTCC-Prozess zur Verbindung der Einzellagen des keramischen Schaltungsträgers erzeugt wird. Somit wird gleichzeitig während der Verbundausbildung der Einzellagen des keramischen Schaltungsträgers auch der Verbundbereich in seiner endgültigen Ausgestaltung erzeugt, indem zum einen die metallische Verbundschicht zur reaktiven Verbunderzeugung mit dem keramischen Schaltungsträger während dieses Prozesses ausgebildet ist und zum anderen der eutektische Bereich während dieses Prozesses zwischen der metallischen Verbundschicht und dem metallischen Kühlkörper erzeugt wird. Besonders bevorzugt erweist es sich, wenn die Metallpaste und somit die metallische Verbundschicht anteilig aus Silber ausgebildet ist und derartige Partikel aufweist und der Kühlkörper zumindest anteilig aus Kupfer ausgebildet ist. Dadurch lässt sich ein eutektischer Bereich während des LTCC-Prozesses zur Verbindung der Einzellagen des keramischen Schaltungsträgers erzeugen, bei dem beispielsweise bei einem 40 %-igen Silberanteil ein Eutektikum mit einer Schmelztemperatur von etwa 779°C ausgebildet werden kann. Dieses kann sich somit bei den bevorzugten Prozesstemperaturen von 900°C bei diesem LTCC-Prozess relativ leicht bilden. Darüber hinaus kann auch eine mit Goldpartikeln versehene Metallpaste als metallische Verbundschicht vorgesehen sein, welche ein Eutektikum mit einem 43,5 %-igen Goldanteil und einer Schmelztemperatur bei etwa 889°C bildet.

### Kurze Beschreibung der Zeichnungen

Ein Ausführungsbeispiel der Erfindung wird nachfolgend anhand schematischer Zeichnungen näher erläutert. Es zeigen:
- Fig. 1: eine Schnittdarstellung durch ein Ausführungsbeispiel eines erfindungsgemäßen elektronischen Bauelementmoduls; und
- Fig. 2: ein Phasendiagramm für das System Silber-Kupfer für einen eutektischen Bereich des Verbundbereichs des elektronischen Bauelementmoduls.

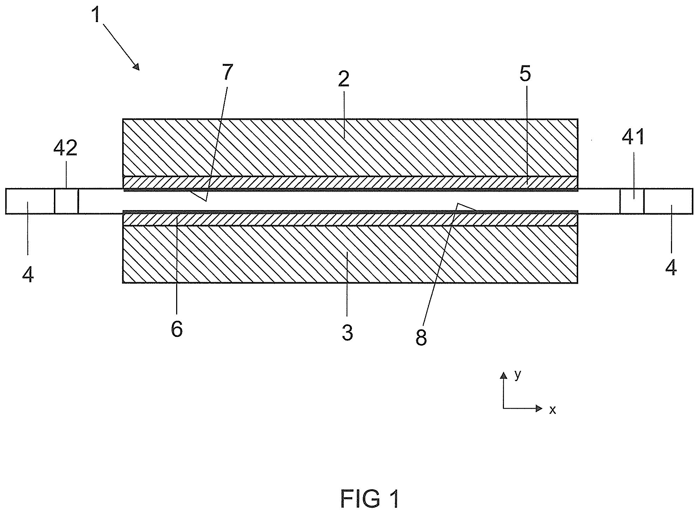

Das elektronische Bauelementmodul 1 umfasst gemäß Fig. 1 einen ersten mehrlagigen keramischen LTCC-Schaltungsträger 2 und einen zweiten mehrlagigen keramischen LTCC-Schaltungsträger 3. Diese beiden Schaltungsträger 2 und 3 sind an gegenüberliegenden Seiten eines Kühlkörpers 4 angeordnet, welcher einer Kühlungsvorrichtung zugeordnet ist. Im Ausführungsbeispiel ist der Kühlkörper 4 somit integral in dem elektronischen Bauelementmodul 1 zwischen den beiden Schaltungsträgern 2 und 3 angeordnet. Der Kühlkörper 4 erstreckt sich in lateraler Richtung (x-Richtung) beidseitig über die Ausmaße der LTCC-Schaltungsträger 2 und 3 hinaus. Darüber hinaus sind Bohrungen 41 und 42 in dem Kühlkörper 4 ausgebildet, welche zur Befestigung, insbesondere Verschraubung, mit weiteren Komponenten oder einem Gehäuse vorgesehen sind.

Zwischen dem oberen LTCC-Schaltungsträger 2 und dem Kühlkörper 4, welcher im Ausführungsbeispiel aus Kupfer ausgebildet ist, ist eine erste Verbundschicht 5 ausgebildet, welche diesen ersten Schaltungsträger 2 mit dem Kühlkörper 4 mechanisch stabil verbindet. In entsprechender Weise ist zwischen dem Kühlkörper 4 und dem zweiten LTCC-Schaltungsträger 3 ebenfalls eine Verbundschicht 6 ausgebildet. Beide Verbundschichten 5 und 6 sind zur reaktiven Verbindung mit den keramischen LTCC-Schaltungsträgern 2 und 3 ausgebildet. Dies bedeutet, dass während des LTCC-Prozesses zum Verbinden der jeweiligen Einzellagen der Schaltungsträger 2 und 3 auch der Verbund zwischen der Verbundschicht 5 und dem ersten Schaltungsträger 2 sowie der Verbund zwischen der zweiten Verbundschicht 6 und dem zweiten Schaltungsträger 3 ausgebildet wird.

Im Ausführungsbeispiel sind die Verbundschichten 5 und 6 jeweils vollflächig zwischen dem Kühlkörper 4 und dem jeweiligen Schaltungsträger 2 und 3 ausgebildet. Es kann auch vorgesehen sein, dass die Verbundschichten 5 und 6 jeweils nur bereichsweise ausgebildet sind. Insbesondere sind die Verbundschichten 5 und 6 an denjenigen Stellen ausgebildet, an denen aufgrund der Anordnung von elektronischen Bauteilen in den jeweiligen Schaltungsträgern 2 und 3 die größte Wärmeerzeugung erfolgt. Durch eine derartige zielgerichtete örtliche Ausbildung der Verbundschichten 5 und 6 kann dann ein bestmöglicher Wärmeabtransport erfolgen. Dieser Wärmeabtransport erfolgt in dem gezeigten Ausführungsbeispiel lateral.

In Fig. 1 ist des Weiteren ein erster eutektischer Bereich 7 zwischen der metallischen Verbundschicht 5 und dem Kühlkörper 4 ausgebildet. Des Weiteren ist ein zweiter eutektischer Bereich 8 zwischen der zweiten metallischen Verbundschicht 6 und dem Kühlkörper 4 ausgebildet. Die beiden eutektischen Bereiche 7 und 8 bilden somit jeweils Teilbereiche aus der metallischen Verbundschicht 5 und dem Kühlkörper 4 einerseits und der metallischen Verbundschicht 6 und dem Kühlkörper 4 andererseits.

Im Ausführungsbeispiel sind die metallischen Verbundschichten 5 und 6 zumindest anteilig mit Silberpartikeln versehen. Der Kühlkörper 4 ist zumindest anteilig aus Kupfer ausgebildet. Dadurch können sich die eutektischen Bereiche 7 und 8 während des LTCC-Prozesses zur Verbindung der Komponenten ausbilden.

Im Ausführungsbeispiel wird das schematisch gezeigte elektronische Bauelementmodul 1 so hergestellt, dass zunächst die Einzellagen der Schaltungsträger 2 und 3 mit den jeweiligen elektronischen Bauteilen und elektrischen Leitungen erzeugt werden. Dann wird eine LTCC-kompatible Metallpaste auf die dem Kühlkörper 4 zugewandten Seiten der Schaltungsträger 2 und 3 ganzflächig oder in einem speziell gewählten Muster aufgebracht, insbesondere aufgedruckt. In einem nachfolgenden LTCC-Prozess, bei dem die jeweiligen Einzellagen der Schaltungsträger 2 und 3 miteinander verbunden werden, insbesondere miteinander laminiert und dann gesintert werden, werden dann auch die jeweiligen Verbundbereiche, welcher erste Verbundbereich die metallische Verbundschicht 5 und den eutektischen Bereich 7 und welcher zweite Verbundbereich die metallische Verbundschicht 6 und den eutektischen Bereich 8 umfasst, erzeugt. Das Sintern der Schaltungsträger 2 und 3 erfolgt bei einer Temperatur von etwa 900°C. Während dieses Prozesses wird auch der Verbund ausgebildet, in dem eine reaktive Verbunderzeugung zwischen der Verbundschicht 5 mit dem keramischen Schaltungsträger 2 und eine reaktive Verbunderzeugung zwischen dem Schaltungsträger 3 und der metallischen Verbundschicht 6 erfolgt. Des Weiteren wird während dieses LTCC-Prozesses auch eine reaktive Verbunderzeugung zwischen der metallischen Verbundschicht 5 und dem Kühlkörper 4 erzeugt und dadurch der eutektische Bereich 7 ausgebildet. In entsprechender Weise erfolgt die Ausbildung des eutektischen Bereichs 8.

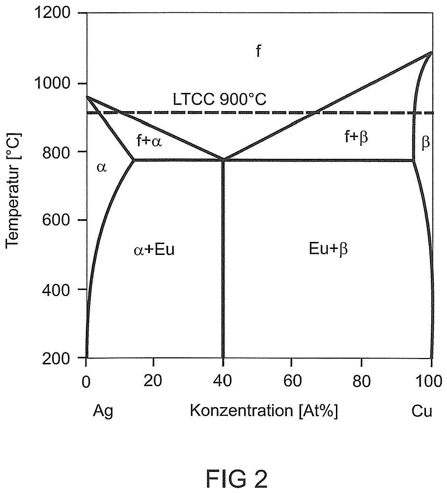

Aufgrund der im Ausführungsbeispiel gewählten Materialien werden als eutektische Bereiche 7 und 8 Silber-Kupfer-Systeme gebildet. In Fig. 2 ist ein Phasendiagramm für ein derartiges Silber-Kupfer-System gezeigt, bei dem mit einem beispielhaften Silberanteil von 40 % ein Eutektikum mit einer Schmelztemperatur von etwa 779°C ausgebildet wird. Dieses kann sich somit bei der Prozesstemperatur von 900°C beim Sintern leicht bilden.

## Patentansprüche

1. Elektronisches Bauelementmodul mit zumindest einem keramischen Schaltungsträger (2, 3) und einer Kühlungsvorrichtung mit zumindest einem Kühlkörper (4),
**dadurch gekennzeichnet, dass**
zwischen dem keramischen Schaltungsträger (2, 3) und der Kühlungsvorrichtung (4) ein Verbundbereich (5, 7; 6, 8) zum Verbinden des Schaltungsträgers (2, 3) mit der Kühlungsvorrichtung (4) ausgebildet ist, **dadurch gekennzeichnet, dass** der Verbundbereich (5, 7; 6, 8) eine zumindest anteilig aus Metall ausgebildete Verbundschicht (5, 6) und einen eutektischen Bereich (7, 8) umfasst, wobei der eutektische Bereich (7, 8) zwischen der Verbundschicht (5, 6) und der metallischen Kühlungsvorrichtung (4) angeordnet ist, und der eutektische Bereich (7, 8) somit jeweils einen Teilbereich aus der metallischen Verbundschicht (5, 6) und dem Kühlkörper (4) bildet.

2. Elektronisches Bauelementmodul nach Anspruch 1,
**dadurch gekennzeichnet, dass**
der Verbundbereich (5, 7; 6, 8) vollflächig zwischen dem Schaltungsträger (2, 3) und der Kühlungsvorrichtung (4) ausgebildet ist.

3. Elektronisches Bauelementmodul nach einem der vorhergehenden Ansprüche,
**dadurch gekennzeichnet, dass**
die metallische Verbundschicht (5, 6) als Metallpaste vor dem Zusammenfügen der Einzellagen des Schaltungsträgers mit der Kühlungsvorrichtung zumindest bereichsweise auf dem Schaltungsträger (2, 3) aufgebracht ist.

4. Elektronisches Bauelementmodul nach einem der vorhergehenden Ansprüche,
**dadurch gekennzeichnet, dass**
der Schaltungsträger als keramischer LTCC-Schaltungsträger (2, 3) ausgebildet ist.

5. Elektronisches Bauelementmodul nach einem der vorhergehenden Ansprüche,
**dadurch gekennzeichnet, dass**
der Schaltungsträger als keramischer LTCC-Schaltungsträger (2, 3) ausgebildet ist und der eutektische Bereich (7, 8) zur reaktiven Verbunderzeugung mit der Kühlungsvorrichtung (4) während dem LTCC-Prozess zur Verbindung der Einzellagen des keramischen Schaltungsträgers (2, 3) erzeugbar ist.

6. Elektronisches Bauelementmodul nach einem.der vorhergehenden Ansprüche,
**dadurch gekennzeichnet, dass**
sich der Kühlkörper (4) zumindest an einer Seite lateral über die Ausmaße des Schaltungsträgers (2, 3) hinaus erstreckt.

7. Elektronisches Bauelementmodul nach einem der vorhergehenden Ansprüche,
**dadurch gekennzeichnet, dass**
der Verbund zwischen dem Schaltungsträger (2, 3), dem Verbundbereich (5, 7; 6, 8) und der Kühlungsvorrichtung (4) durch einen Sinterprozess bei einer Temperatur zwischen 840°C und 930°C, insbesondere bei etwa 900°C, ausgebildet ist.

8. Verfahren zum Herstellen eines elektronischen Bauelementmoduls (1) bei dem zumindest ein mehrlagiger keramischer Schaltungsträger (2, 3) ausgebildet wird und mit einer Kühlungsvorrichtung mit zumindest einem Kühlkörper (4) verbunden wird,
**dadurch gekennzeichnet, dass**
der Schaltungsträger (2, 3) und die Kühlungsvorrichtung (4) durch einen Verbundbereich (5, 7; 6, 8) verbunden werden, welcher Verbundbereich (5, 7; 6, 8) durch eine zur Verbindung mit einem keramischen Material und zumindest anteilig aus Metall ausgebildete Verbundschicht (5, 6) und ein eutektischer Bereich (7, 8) ausgebildet wird, wobei der eutektische Bereich (7, 8) zwischen der metallischen Verbundschicht (5, 6) und der Kühlungsvorrichtung (4) ausgebildet wird, und der eutektische Bereich (7, 8) somit jeweils einen Teilbereich aus der metallischen Verbundschicht (5, 6) und dem Kühlkörper (4) bildet.

9. Verfahren nach Anspruch 8,
**dadurch gekennzeichnet, dass**
vor dem Prozess zum Verbinden der Einzellagen des Schaltungsträgers (2, 3) eine metallhaltige Paste auf den Schaltungsträger (2, 3) und/oder die Kühlvorrichtung (4) angebracht wird und daraus die metallische Verbundschicht (5, 6) während des Prozesses zum Verbinden der Einzellagen des Schaltungsträgers (2, 3) ausgebildet wird.

10. Verfahren nach einem der Ansprüche 8 oder 9,
**dadurch gekennzeichnet, dass**
der eutektische Bereich (7, 8) während dem Verbinden zwischen dem Schaltungsträger (2, 3), der Verbundschicht (5, 6) und der Kühlungsvorrichtung (4) ausgebildet wird.

11. Verfahren nach Anspruch 10 ,
**dadurch gekennzeichnet, dass**
der eutektische Bereich (7, 8) durch eine Materialverbindung mit einer Schmelztemperatur kleiner der Prozesstemperatur, bei der der Schaltungsträger (2, 3), die Verbundschicht (5, 6) und die Kühlungsvorrichtung (4) miteinander verbunden werden, ausgebildet wird.

12. Verfahren nach Anspruch 10 oder 11,
**dadurch gekennzeichnet, dass**
der Schaltungsträger (2, 3), die Verbundschicht (5, 6) und die Kühlungsvorrichtung (4) durch Sintern bei einer Temperatur zwischen 840°C und 930°C, insbesondere bei etwa 900°C, verbunden werden.

13. Verfahren nach einem der Ansprüche 8 bis 12,
**dadurch gekennzeichnet, dass**
der Schaltungsträger als keramischer LTCC-Schaltungsträger (2, 3) ausgebildet wird und der eutektische Bereich (7, 8) zur reaktiven Verbunderzeugung mit der Kühlungsvorrichtung (4) während dem LTCC-Prozess zur Verbindung der Einzellagen des keramischen Schaltungsträgers (2, 3) zwischen der Verbundschicht (5, 6) und der Kühlungsvorrichtung (4) erzeugt wird.

14. Verfahren nach einem der Ansprüche 10 bis 13,
**dadurch gekennzeichnet, dass**
die Verbundschicht (5, 6) zumindest anteilig aus Glas ausgebildet wird, insbesondere durch einen Siebdruck aufgebracht wird und anschließend temperaturbehandelt wird.

## Claims

1. Electronic component module with at least one ceramic circuit carrier (2, 3) and a cooling device with at least one heat sink (4), **characterized in that** formed between the ceramic circuit carrier (2, 3) and the cooling device (4) is a bonding region (5, 7; 6, 8) for bonding the circuit carrier (2, 3) to the cooling device (4), **characterized in that** the bonding region (5, 7; 6, 8) comprises a bonding layer (5, 6) formed at least in part from metal and a eutectic region (7, 8) wherein the eutectic region (7, 8) is arranged between the bonding layer (5, 6) and the metallic cooling device (4), and the eutectic region (7, 8) thus in each case forms a partial region consisting of the metallic bonding layer (5, 6) and the heat sink (4).

2. Electronic component module according to Claim 1, **characterized in that** the bonding region (5, 7; 6, 8) is formed over the full surface area between the circuit carrier (2, 3) and the cooling device (4).

3. Electronic component module according to one of the preceding claims, **characterized in that** the metallic bonding layer (5, 6) is applied at least to certain regions on the circuit carrier (2, 3) as a metal paste before the individual layers of the circuit carrier are joined together with the cooling device.

4. Electronic component module according to one of the preceding claims, **characterized in that** the circuit carrier is formed as a ceramic LTCC circuit carrier (2, 3).

5. Electronic component module according to one of the preceding claims, **characterized in that** the circuit carrier is formed as a ceramic LTCC circuit carrier (2, 3) and the eutectic region (7, 8) can be produced for creating a reactive bond with the cooling device (4) during the LTCC process for bonding the individual layers of the ceramic circuit carrier (2, 3).

6. Electronic component module according to one of the preceding claims, **characterized in that** the heat sink (4) extends at least on one side laterally beyond the extent of the circuit carrier (2, 3).

7. Electronic component module according to one of the preceding claims, **characterized in that** the bond between the circuit carrier (2, 3), the bonding region (5, 7; 6, 8) and the cooling device (4) is formed by a sintering process at a temperature between 840°C and 930°C, in particular at approximately 900°C.

8. Method for producing an electronic component module (1) in which at least one multilayered ceramic circuit carrier (2, 3) is formed and bonded to a cooling device with at least one heat sink (4), **characterized in that** the circuit carrier (2, 3) and the cooling device (4) are bonded by a bonding region (5, 7; 6, 8), which bonding region (5, 7; 6, 8) is designed for bonding to a ceramic material and is formed by a bonding layer (5, 6) formed at least in part from metal and a eutectic region (7, 8), the eutectic region (7, 8) is formed between the metallic bonding layer (5, 6) and the cooling device (4), and the eutectic region (7, 8) thus in each case forms a partial region consisting of the metallic bonding layer (5, 6) and the heat sink (4).

9. Method according to Claim 8, **characterized in that** a metal-containing paste is applied to the circuit carrier (2, 3) and/or the cooling device (4) before the process of bonding the individual layers of the circuit carrier (2, 3) and the metallic bonding layer (5, 6) is formed from said paste during the process of bonding the individual layers of the circuit carrier (2, 3).

10. Method according to either of Claims 8 or 9, **characterized in that** the eutectic region (7, 8) is formed during the bonding between the circuit carrier (2, 3), the bonding layer (5, 6) and the cooling device (4).

11. Method according to Claim 10, **characterized in that** the eutectic region (7, 8) is formed by a material bond with a melting temperature lower than the process temperature at which the circuit carrier (2, 3), the bonding layer (5, 6) and the cooling device (4) are bonded to one another.

12. Method according to Claim 10 or 11, **characterized in that** the circuit carrier (2, 3), the bonding layer (5, 6) and the cooling device (4) are bonded by sintering at a temperature between 840°C and 930°C, in particular at approximately 900°C.

13. Method according to one of Claims 8 to 12, **characterized in that** the circuit carrier is formed as a ceramic LTCC circuit carrier (2, 3) and the eutectic region (7, 8) is produced between the bonding layer (5, 6) and the cooling device (4) for creating a reactive bond with the cooling device (4) during the LTCC process for bonding the individual layers of the ceramic circuit carrier (2, 3).

14. Method according to one of Claims 10 to 13, **characterized in that** the bonding layer (5, 6) is formed at least in part from glass, in particular is applied by screen printing, and is subsequently thermally treated.

## Revendications

1. Module de composant électronique avec au moins un porte-circuit céramique (2, 3) et un dispositif de refroidissement avec au moins un déperditeur de chaleur (4),
**caractérisé en ce que**
entre le porte-circuit céramique (2, 3) et le dispositif de refroidissement (4) est réalisée une région de liaison (5, 7 ; 6, 8) destinée à relier le porte-circuit (2, 3) avec le dispositif de refroidissement (4), **caractérisé en ce que** la région de liaison (5, 7 ; 6, 8) comprend une couche de liaison (5, 6) réalisée au moins en partie en métal et une région eutectique (7, 8), dans lequel la région eutectique (7, 8) est agencée entre la couche de liaison (5, 6) et le dispositif de refroidissement métallique (4), et la région eutectique (7, 8) forme ainsi respectivement une sous-région de la couche de liaison métallique (5, 6) et du déperditeur de chaleur (4).

2. Module de composant électronique selon la revendication 1,
**caractérisé en ce que**
la région de liaison (5, 7 ; 6, 8) est réalisée sur toute la surface entre le porte-circuit (2, 3) et le dispositif de refroidissement (4).

3. Module de composant électronique selon l'une quelconque des revendications précédentes,
**caractérisé en ce que**
la couche de liaison métallique (5, 6) est appliquée au moins par région sur le porte-circuit (2, 3) sous forme de pâte métallique avant la réunion des strates individuelles du porte-circuit avec le dispositif de refroidissement.

4. Module de composant électronique selon l'une quelconque des revendications précédentes,
**caractérisé en ce que**
le porte-circuit est réalisé sous forme de porte-circuit céramique à base de céramiques cofrittées à basse température (2, 3).

5. Module de composant électronique selon l'une quelconque des revendications précédentes,
**caractérisé en ce que**
le porte-circuit est réalisé sous forme de porte-circuit céramique à base de céramiques cofrittées à basse température (2, 3) et la région eutectique (7, 8) destinée à une production réactive de liaison avec le dispositif de refroidissement (4) peut être produite pendant le procédé de cofrittage de céramiques à basse température destiné à lier les strates individuelles du porte-circuit céramique (2, 3).

6. Module de composant électronique selon l'une quelconque des revendications précédentes,
**caractérisé en ce que**
le déperditeur de chaleur (4) s'étend latéralement au-delà des dimensions du porte-circuit (2, 3) au moins au niveau d'un côté.

7. Module de composant électronique selon l'une quelconque des revendications précédentes,
**caractérisé en ce que**
la liaison entre le porte-circuit (2, 3), la région de liaison (5, 7 ; 6, 8) et le dispositif de refroidissement (4) est réalisée grâce à un procédé de frittage à une température comprise entre 840°C et 930°C, en particulier d'environ 900°C.

8. Procédé de fabrication d'un module de composant électronique (1), dans lequel au moins un porte-circuit céramique multi strates (2, 3) est réalisé et est relié à un dispositif de refroidissement comportant au moins un déperditeur de chaleur (4),
**caractérisé en ce que**
le porte-circuit (2, 3) et le dispositif de refroidissement (4) sont reliés grâce à une région de liaison (5, 7 ; 6, 8), ladite région de liaison (5, 7 ; 6, 8) étant réalisée grâce à une couche de liaison (5, 6), réalisée en vue d'une liaison avec un matériau céramique et au moins en partie en métal, et à une région eutectique (7, 8), dans lequel la région eutectique (7, 8) est réalisée entre la couche de liaison métallique (5, 6) et le dispositif de refroidissement (4), et la région eutectique (7, 8) forme ainsi respectivement une sous-région de la couche de liaison métallique (5, 6) et du déperditeur de chaleur (4).

9. Procédé selon la revendication 8,
**caractérisé en ce que**
avant le procédé destiné à lier les strates individuelles du porte-circuit (2, 3), une pâte contenant du métal est appliquée sur le porte-circuit (2, 3) et/ou sur le dispositif de refroidissement (4) et la couche de liaison métallique (5, 6) est réalisée à partir de celle-ci pendant le procédé destiné à lier les strates individuelles du porte-circuit (2, 3).

10. Procédé selon la revendication 8 ou 9,
**caractérisé en ce que**
la région eutectique (7, 8) est réalisée pendant la liaison entre le porte-circuit (2, 3), la couche de liaison (5, 6) et le dispositif de refroidissement (4).

11. Procédé selon la revendication 10,
**caractérisé en ce que**
la région eutectique (7, 8) est réalisée par une liaison de matériau à une température de fusion inférieure à la température de procédé à laquelle le porte-circuit (2, 3), la couche de liaison (5, 6) et le dispositif de refroidissement (4) sont liés les uns aux autres.

12. Procédé selon la revendication 10 ou 11
**caractérisé en ce que**
le porte-circuit (2, 3), la couche de liaison (5, 6) et le dispositif de refroidissement (4) sont liés par frittage à une température comprise entre 840°C et 930°C, en particulier d'environ 900°C.

13. Procédé selon l'une quelconque des revendications 8 à 12,
**caractérisé en ce que**
le porte-circuit est réalisé sous forme de porte-circuit céramique à base de céramiques cofrittées à basse température (2, 3) et la région eutectique (5, 8) destinée à une production réactive de liaison avec le dispositif de refroidissement (4) est produite entre la couche de liaison (5, 6) et le dispositif de refroidissement (4) pendant le procédé de cofrittage de céramiques à basse température destiné à une liaison des strates individuelles du porte-circuit céramique (2, 3).

14. Procédé selon l'une quelconque des revendications 10 à 13
**caractérisé en ce que**
la couche de liaison (5, 6) est réalisée au moins en partie en verre, est en particulier appliquée grâce à un procédé de sérigraphie et est ensuite traitée grâce à un procédé thermique.
